# EUROPÄISCHE PATENTSCHRIFT

(11) **EP 3 281 504 B1**
(45) Veröffentlichungstag und Bekanntmachung des Hinweises auf die Patenterteilung: **04.12.2019**
(21) Anmeldenummer: 16719197.2
(22) Anmeldetag: 23.03.2016
(51) Int. Cl.: H05K 7/20

(54) **KÜHLGERÄT FÜR DIE SCHALTSCHRANKKLIMATISIERUNG**
COOLING DEVICE FOR SWITCH CABINET AIR-CONDITIONING
APPAREIL DE REFROIDISSEMENT POUR CLIMATISATION D'ARMOIRE DE DISTRIBUTION

(30) Priorität: 10.04.2015 DE 102015105500
(43) Veröffentlichungstag der Anmeldung: 14.02.2018
(73) Patentinhaber: Rittal GmbH & Co. KG, 35745 Herborn (DE)
(72) Erfinder: CACHO ALONSO, Juan Carlos, 38102 Braunschweig (DE); WERB, Phlipp, 65551 Limburg- Lindenholzhausen (DE)
(74) Vertreter: Angerhausen, Christoph
(86) Internationale Anmeldenummer: PCT/DE2016/100141
(87) Internationale Veröffentlichungsnummer: WO 2016/162013

(56) Entgegenhaltungen:
- WO-A1-2014/032649
- WO-A1-2014/068651

## Beschreibung

Die Erfindung geht aus von einem Kühlgerät für die Schaltschrankklimatisierung, das einen Innenkreis, durch den zu kühlende Luft aus einem Schaltschrankinnenraum mittels eines ersten Lüfters geführt ist, und einen von dem Innenkreis fluidisch abgetrennten Außenkreis aufweist, durch den Umgebungsluft mittels eines zweiten Lüfters geführt ist, wobei der Innenkreis und der Außenkreis über ein Trennelement fluidisch voneinander getrennt sind, und wobei ein Inverter, über den ein Verdichter des Kühlgeräts angesteuert ist, an einer ersten von zwei gegenüber liegenden Seiten einen Wärmetauscher zum Abtausch von Abwärme an den Wärmetauscher umgebende Luft und an einer zweiten der zwei gegenüber liegenden Seiten einen Elektronikteil mit einer Mehrzahl elektronischer Bauteile aufweist. Ein derartiges Kühlgerät ist aus der DE 10 2012 108 110 A1 bekannt. Ähnliche Kühlgeräte sind außerdem in der WO 2014/068651 A1, der DE 44 45 818 A1, der US 2012/261100 A1 sowie in der EP 1 610 452 A2 beschrieben.

Das Kühlgerät aus der DE 10 2012 108 110 A1 kann als Wandanbau- oder als Dachaufbaugerät ausgebildet sein. Über eine Lufteinlassöffhung wird erwärmte Luft aus dem Schaltschrankinnenraum in den Innenkreis eingeleitet. Die erwärmte Luft aus dem Schaltschrankinnenraum passiert einen Luft-Kältemittel-Wärmetauscher im Innenkreis und wird als gekühlte Luft über eine Luftauslassöffhung in den Schaltschrankinnenraum zurückgeführt. Der Außenkreis weist eine weitere Lufteinlassöffnung und eine weitere Luftauslassöffhung auf, über welche Umgebungsluft der Schaltschrankanordnung in den Außenkreis eingeleitet, durch den im Außenkreis angeordneten Luft-Kältemittel-Wärmetauscher hindurch und über die Luftauslassöffhung zurück in die Umgebung geleitet wird.

Die beiden Luft-Kühlmittel-Wärmetauscher bilden zusammen mit den Lüftern für den Lufttransport durch den Innen- bzw. Außenkreis sowie einem Verdichter und einem Expansionsmittel die wesentlichen Komponenten einer Kältemaschine. Dabei ist der Inverter darauf ausgelegt, entsprechend einem ermittelten Kühlleitungsbedarf, den Verdichter mit einer Steuerspannung zu versorgen, so dass sich eine zur Erzielung des erforderten Kühlleistungsbedarfs notwendige Verdichterdrehzahl einstellt.

Der Inverter ist ein Spannungswandler, der aus einer Netzspannung, beispielsweise einer 50 Hertz Wechselspannung, eine für den Betrieb des Verdichters erforderliche Betriebsspannung erzeugt. Dies kann beispielsweise auch die Bereitstellung eines Drehstroms für den Verdichter umfassen. Die für den Bau von Kühlgeräten verwendeten Inverter umfassen häufig einen Elektronikteil, der auf einer ersten Seite des Inverters ausgebildet ist und im Wesentlichen passive elektrische Bauteile mit geringer Verlustleistung und Wärmeabstrahlung aufweist, und einen Wärmetauscher, über den die bei der Spannungswandlung durch aktive Bauteile, wie IGBTs, entstehende Abwärme abgeführt wird, wobei zumindest dieser Wärmetauscher und häufig auch die Wärme erzeugenden Bauteile an einer dem Elektronikteil gegenüberliegenden Seite des Inverters ausgebildet sind.

Um eine optimale Abführung der Abwärme zu gewährleisten, ist bei den aus dem Stand der Technik bekannten Kühlgeräten der Inverter im Außenkreis angeordnet. Wäre er im Innenkreis angeordnet, würde die Abwärme des Inverters die Schaltschrankinnenraumluft beaufschlagen und damit den Wirkungsgrad des Kühlgerätes negativ beeinflussen. Der Elektronikteil des Inverters ist jedoch empfindlich gegenüber Feuchtigkeit und wird daher häufig gekapselt, um etwa zu vermeiden, dass Spritzwasser, das in den Außenkreis gelangt, oder Kondensat mit dem Elektronikteil in Berührung kommt.

Es ist daher die Aufgabe der Erfindung, ein Kühlgerät der zuvor beschriebenen Art derart weiterzuentwickeln, dass der Elektronikteil des Inverters mit möglichst einfachen technischen Mitteln vor Feuchtigkeit geschützt ist, ohne dadurch den Wirkungsgrad des Kühlgeräts über Gebühr zu beeinträchtigen.

Diese Aufgabe wird erfindungsgemäß durch ein Kühlgerät mit den Merkmalen des Anspruchs 1 gelöst. Die abhängigen Ansprüche betreffen jeweils vorteilhafte Ausführungsformen der Erfindung.

Demgemäß ist bei dem Kühlgerät zumindest der Wärmetauscher der ersten Seite des Inverters in dem Außenkreis und zumindest der Elektronikteil der zweiten Seite des Inverters im Innenkreis angeordnet. Dadurch wird erreicht, dass einerseits die über den Wärmetauscher des Inverters abgeleitete Wärme weiterhin lediglich den Außenkreis, jedoch nicht den Innenkreis beaufschlagt, während gleichzeitig der Elektronikteil vor in den Außenkreis eindringender Feuchtigkeit geschützt aufgenommen ist. Das Kühlgerät kann beispielsweise eine Taupunktregelung aufweisen, wie sie aus dem Stand der Technik hinlänglich bekannt ist, welche es zusätzlich wirkungsvoll vermeidet, dass sich Kondensat im Innenkreis bildet.

Es kann vorgesehen sein, dass die gegenüberliegenden Seiten des Inverters von einer elektronischen Leiterkarte des Inverters gebildet sind. Anstelle der Leiterkarte kann auch ein anderer Geräte- und/oder Komponententräger vorgesehen sein, welcher dazu geeignet ist, den Wärmetauscher und den Elektronikteil an gegenüberliegenden Seiten räumlich und fluidisch voneinander zu separieren.

Der Inverter kann in einem Durchbruch des Trennelements zwischen dem Innenkreis und dem Außenkreis eingesetzt sein, so dass die erste Seite des Inverters in dem Außenkreis und die zweite Seite des Inverters in dem Innenkreis angeordnet ist.

Dazu kann der Inverter zwischen den gegenüberliegenden Seiten einen umlaufenden Flansch aufweisen, über den der Inverter fluidisch dicht mit dem Trennelement verbunden ist, so dass der Durchbruch über den Inverter verschlossen ist. Dieser Flansch kann von einer Berandung einer Leiterkarte gebildet sein.

Um einen besonders effektiven Wärmeabtausch über den Wärmetauscher des Inverters zu erreichen, kann vorgesehen sein, dass der Wärmetauscher an einer Stirnseite, mit der der Wärmetauscher in den Außenkreis hineinragt, eine metallische Wärmetauscherplatte aufweist.

Eine besonders gute Anströmung des Wärmetauschers wird dadurch erreicht, dass bei einem Kühlgerät, bei dem in dem Außenkreis ein erster Luft-Kühlmittel-Wärmetauscher angeordnet ist, die erste Seite des Inverters in dem Außenkreis in Fluidströmungsrichtung durch den Außenkreis zwischen dem ersten Luft-Kühlmittel-Wärmetauscher und dem zweiten Lüfter angeordnet ist.

Um auch den Elektronikteil noch besser vor Feuchtigkeit, insbesondere Kondensat, zu schützen, kann vorgesehen sein, dass der Inverter mit seinem Elektronikteil im Luftstrom durch den Innenkreis und mit seinem Wärmetauscher im Luftstrom durch den Außenkreis angeordnet ist. Das Kühlgerät kann dabei eine Kältemaschine mit einem Verdichter in dem Außenkreis, einem ersten Luft-Kühlmittel-Wärmetauscher in dem Außenkreis sowie einem zweiten Kühlmittel-Wärmetauscher in dem Innenkreis sein.

Weiterhin kann die Anströmung des Wärmetauschers des Inverters dadurch noch verbessert werden, dass das Kühlgerät ein Luftleitelement aufweist, über das die den Außenkreis durchströmende Luft auf den Wärmetauscher gelenkt wird. Das Luftleitblech kann dabei Bestandteil des Trennelements und/oder an dieses angeformt sein. Weiterhin kann das Trennelement ein Kunststoffformteil, insbesondere ein Spritzgussformteil, oder ein tiefgezogenes Kunststoff- oder Metallbauteil sein.

Weitere Einzelheiten der Erfindung werden anhand der nachstehenden Figuren erläutert. Dabei zeigt:
- Figur 1: eine Schaltschrankanordnung, aus einem Schaltschrank und einem Kühlgerät gemäß einer Ausführungsform der Erfindung; und
- Figur 2: eine Ausschnittsansicht des Bereichs des Kühlgeräts gemäß Figur 1, in dem der Inverter angeordnet ist.

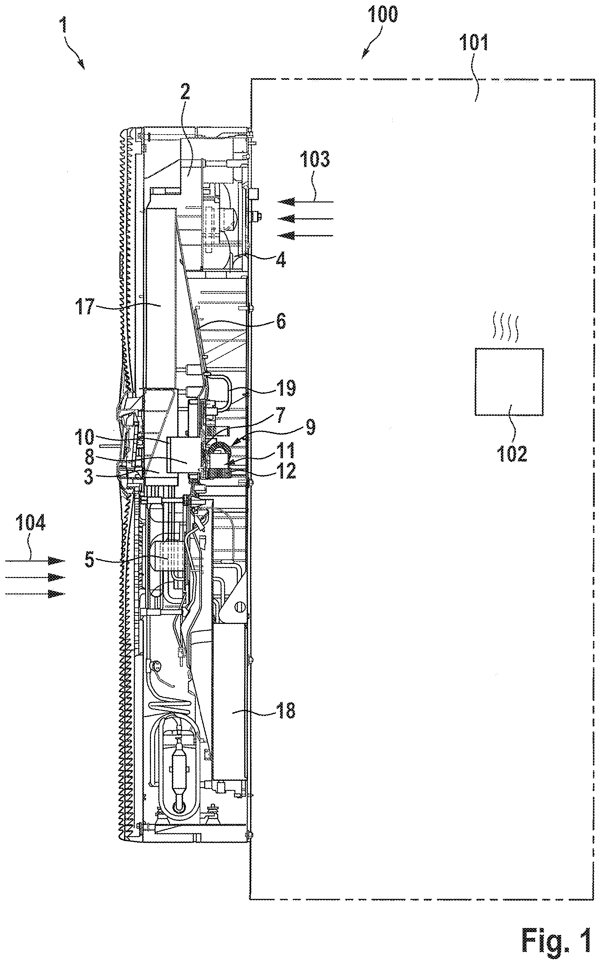

Die in Figur 1 gezeigte Schaltschrankanordnung besteht aus dem Schaltschrank 100 und einem Kühlgerät 1, das als ein Wandanbaugerät ausgebildet und an einer Seitenwand des Schaltschranks 100 montiert ist. Über Durchbrüche in der Seitenwand steht der Innenkreis 2 des Kühlgeräts 1 mit dem Schaltschrankinnenraum 101 fluidisch in Verbindung. Ein erster Lüfter 4 in dem Innenkreis 2 zieht die Luft 103 aus dem Schaltschrankinnenraum 101 in den Innenkreis 2, transportiert diese durch den Innenkreis 2 an dem Inverter 7 vorbei und durch den zweiten Luft-Kühlmittel-Wärmetauscher 18 hindurch. Nachdem die zu kühlende Luft 103 den zweiten Luft-Kühlmittel-Wärmetauscher 18 passiert hat, wird sie als gekühlte Luft in den Schaltschrankinnenraum 101 zurückgeleitet und kann dort die in dem Schaltschrankinnenraum 101 aufgenommenen, wärmeabgebenden Komponenten 102 kühlen.

Der Innenkreis 2 ist über ein Trennelement 6 von dem Außenkreis 3 des Kühlgeräts 1 luftdicht abgetrennt. In dem Außenkreis 3 ist ein zweiter Lüfter 5 angeordnet, der Umgebungsluft 104 in den Außenkreis 3 ansaugt, durch den Außenkreis 3 an dem Wärmetauscher 10 des Inverters 7 vorbei und durch den ersten Luft-Kältemittel-Wärmetauscher 17 hindurchleitet. Nach dem Passieren des ersten Luft-Kältemittel-Wärmetauschers 17 verlässt die Luft den Außenkreis 3 und wird in die Umgebung zurückgeleitet.

Der erste und der zweite Luft-Kühlmittel-Wärmetauscher 17, 18 bilden zusammen mit den Lüftern 4, 5 und einem Verdichter sowie einem nicht dargestellten Expansionsmittel die wesentlichen Komponenten einer Kältemaschine, wobei in Abhängigkeit eines Kühlleistungsbedarfs die Drehzahl der Lüfter 4, 5 sowie des Verdichters von einem Inverter 7 eingeregelt ist, der eine den erforderlichen Drehzahlen entsprechende Steuerspannung an die Lüfter 4, 5 bzw. den Verdichter bereitstellt. Die Lüfter 4, 5 können Gleichspannungslüfter sein, während der Verdichter ein Drehstromgerät sein kann.

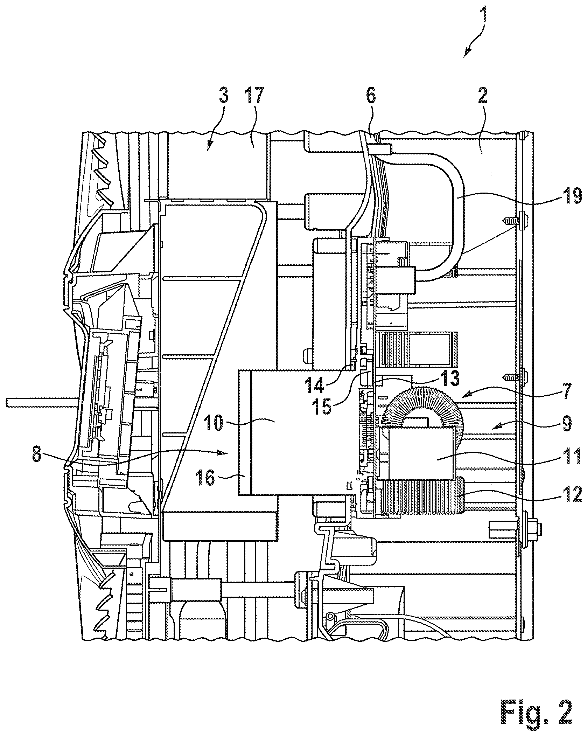

Wie in der Zusammenschau der Figuren 1 und 2 zu erkennen ist, ist der Inverter 7 nunmehr derart in das Trennelement 6 integriert, dass er mit einer ersten Seite 8, an der der Wärmetauscher 10 ausgebildet ist, in den Außenkreis hineinragt, während er mit einer der ersten Seite 8 gegenüberliegenden Seite 9, an der der Elektronikteil 11 ausgebildet ist, in den Innenkreis hineinragt. Der Wärmetauscher 10 weist an seiner äußeren Stirnseite einen Kühlkörper auf. Diese kann zur Oberflächenvergrößerung gerippt sein, oder eine Riffelung oder dergleichen aufweisen, um den Wärmeabtausch zu verbessern.

Der Elektronikteil 11 weist eine Mehrzahl elektronischer Bauteile 12 auf. Diese elektronischen Bauteile sind insbesondere passive elektronische Bauteile, welche keine Abwärme erzeugen. Sofern der Elektronikteil 11 auch aktive Abwärme erzeugende Bauteile aufweist, sind diese derart angeordnet, dass sie für den Wärmeabtausch in den Außenkreis 3 mit dem Wärmetauscher 10 des Inverters 7 thermisch gekoppelt sind. Vorzugsweise sind auf der dem Innenkreis 2 zugewandten Seite 9 des Inverters jedoch keinerlei wärmeabgebenden elektronische Bauteile angeordnet. Es ist zu erkennen, dass die elektronischen Bauteile 12 freiliegend in dem Innenkreis 2 angeordnet sind. Dies ist gerade deshalb möglich, weil die elektronischen Komponenten im Innenkreis wirkungsvoll gegenüber Spritzwasser geschützt sind. Auch die Kondensatbildung auf den elektronischen Bauteilen 12 ist bei Kühlgeräten für die Schalt schrankklimatisierung in der Regel ausgeschlossen, da diese von Haus aus über eine Taupunktregulierung verfügen, welche gerade vermeiden soll, dass sich Kondensat an den im Schaltschrankinnenraum 101 angeordneten elektrischen Schaltanlagen, wie den wärmeabgebenden Komponenten 102 (siehe Figur 1), ausbildet.

Die Erfindung macht sich somit den Umstand zu Nutze, dass die für die Schaltschrankklimatisierung, insbesondere zum Schutz der in dem Schaltschrankinnenraum 101 aufgenommenen, kühlbedürftigen Komponenten 102 erforderlichen, klimatischen Bedingungen auch für den Schutz des Elektronikteils 11 des Inverters 7 geeignet sind.

Der Inverter 7 weist an einer Trennstelle zwischen dem Elektronikteil 11 und dem Wärmetauscher 10 einen umlaufenden Flansch 15 auf, der in einem Durchbruch 14 des Trennelements 6 fluidisch dicht verbunden ist. Das Trennelement 6 kann beispielsweise ein Kunststoffspritzgussformteil sein, in welchen der Durchbruch 14 als ein Ausschnitt eingebracht ist. Für eine optimale Anströmung des Elektronikteils 11 ist ein Luftleitelement 19 vorgesehen. Durch die gezielte Anströmung des Elektronikteils 11 wird wirkungsvoll die Kondensatbildung am Elektronikteil 11 unterbunden.

Der Inverter weist eine Leiterkarte 13 oder ein anderweitiges Trägerelement auf, bei dem an gegenüberliegenden Seiten 8, 9 der Wärmetauscher 10 mit dem Kühlkörper 16 und der Elektronikteil 11 ausgebildet sind. Der umlaufende Flansch 15 kann von der Leiterkarte 13 bzw. dem Trägerelement gebildet oder an diesen umlaufend ausgebildet, beispielsweise abgekantet sein. Zwischen dem Flansch 15 und der Berandung des Trennelements 6 kann ein Dichtelement (nicht dargestellt) vorgesehen sein, um den Durchbruch 14 in dem Trennelement 6 über den Flansch 15 bzw. den Inverter 7 fluidisch dicht zu verschließen, so dass ein Luftkurzschluss zwischen Innenkreis 2 und Außenkreis 3 wirkungsvoll unterbunden wird.

### Bezugszeichenliste

- 1: Kühlgerät
- 2: Innenkreis
- 3: Außenkreis
- 4: Erster drehzahlgeregelter Lüfter
- 5: Zweiter drehzahlgeregelter Lüfter
- 6: Trennelement
- 7: Inverter
- 8: Erste Seite
- 9: Zweite Seite
- 10: Wärmetauscher des Inverters
- 11: Elektronikteil des Inverters
- 12: Elektronische Bauteile des Inverters
- 13: Elektrische Leiterkarte
- 14: Durchbruch
- 15: Flansch
- 16: Kühlkörper
- 17: Erster Luft-Kühlmittel-Wärmetauscher
- 18: Zweiter Luft-Kühlmittel-Wärmetauscher
- 19: Luftleitelement
- 100: Schaltschrank
- 101: Schaltschrankinnenraum
- 102: Wärmeabgebende Komponente
- 103: Zu kühlende Luft im Schaltschrankinnenraum
- 104: Umgebungsluft

## Patentansprüche

1. Kühlgerät (1) für die Schaltschrankklimatisierung, das einen Innenkreis (2), durch den zu kühlende Luft (103) aus einem Schaltschrankinnenraum (101) mittels eines ersten Lüfters (4) geführt ist, und einen von dem Innenkreis (2) fluidisch abgetrennten Außenkreis (3) aufweist, durch den Umgebungsluft (104) mittels eines zweiten Lüfters (5) geführt ist, wobei der Innenkreis (2) und der Außenkreis (3) über ein Trennelement (6) fluidisch voneinander getrennt sind, und wobei ein Inverter (7), über den ein Verdichter des Kühlgeräts (1) angesteuert ist, an einer ersten (8) von zwei gegenüber liegenden Seiten (8, 9) einen Wärmetauscher (10) zum Abtausch von Abwärme an den Wärmetauscher (10) umgebende Luft und an einer zweiten der zwei gegenüber liegenden Seiten (8, 9) einen Elektronikteil (11) mit einer Mehrzahl elektronischer Bauteile (12) aufweist, **dadurch gekennzeichnet, dass** zumindest der Wärmetauscher (10) der ersten Seite (8) des Inverters (7) in dem Außenkreis (3) und zumindest der Elektronikteil (11) der zweiten Seite (9) des Inverters (7) im Innenkreis (2) angeordnet ist.

2. Kühlgerät (1) nach Anspruch 1, bei dem die gegenüber liegenden Seiten des Inverters (7) von einer elektrischen Leiterkarte (13) des Inverters (7) gebildet sind.

3. Kühlgerät (1) nach Anspruch 1 oder 2, bei dem der Inverter (7) in einen Durchbruch (14) des Trennelements (6) zwischen dem Innenkreis (2) und dem Außenkreis (3) eingesetzt ist, so dass die erste Seite (8) des Inverters (7) in dem Außenkreis und die zweite Seite (9) des Inverters (7) im Innenkreis (2) angeordnet ist.

4. Kühlgerät (1) nach Anspruch 3, bei dem der Inverter (7) zwischen den gegenüber liegenden Seiten (8, 9) einen umlaufenden Flansch (15) aufweist, über den der Inverter (7) fluidisch dicht mit dem Trennelement (6) verbunden ist, so dass der Durchbruch (14) über den Inverter (7) verschlossen ist.

5. Kühlgerät (1) nach einem der vorangegangenen Ansprüche, bei dem der Wärmetauscher (10) an einer Stirnseite, mit der der Wärmetauscher (10) in den Außenkreis (3) hineinragt, einen metallische Kühlkörper (16), vorzugsweise einen gerippten Kühlkörper, aufweist.

6. Kühlgerät (1) nach einem der vorangegangen Ansprüche, bei dem in dem Außenkreis (3) ein erster Luft-Kühlmittel-Wärmetauscher (17) angeordnet ist, wobei die erste Seite (8) des Inverters (7) in dem Außenkreis (3) in Fluidströmungsrichtung durch den Außenkreis (3) zwischen dem ersten Luft-Kühlmittel-Wärmetauscher (17) und dem zweiten Lüfter (5) angeordnet ist.

7. Kühlgerät (1) nach einem der vorangegangen Ansprüche, das eine Kältemaschine mit einem Verdichter in dem Außenkreis (3), einen ersten Luft-Kühlmittel-Wärmetauscher (17) in dem Außenkreis (3) und einen zweiten Luft-Kühlmittel-Wärmetauscher (18) in dem Innenkreis (2) aufweist, wobei der Inverter (7) mit seinem Elektronikteil (11) im Luftstrom durch den Innenkreis (2) und mit seinem Wärmetauscher (10) im Luftstrom durch den Außenkreis (3) angeordnet ist.

8. Kühlgerät (1) nach einem der vorangegangen Ansprüche, das ein Luftleitelement (19) aufweist, über das die den Außenkreis (3) durchströmende Luft auf den Wärmetauscher (10) gelenkt ist.

9. Kühlgerät (1) nach Anspruch 8, bei dem das Luftleitelement (19) Bestandteil des Trennelements (6) und/oder an dieses angeformt ist.

10. Kühlgerät (1) nach einem der vorangegangen Ansprüche, bei dem das Trennelement (6) ein Kunststoffformteil, insbesondere ein Spritzgussformteil, oder ein tiefgezogenes Kunststoff- oder Metallbauteil ist.

## Claims

1. Cooling device (1) for the air conditioning of switch cabinets, which comprises an inner circuit (2), through which air (103) to be cooled from an interior of a switch cabinet (101) is directed by means of a first fan (4), and an outer circuit (3) that is fluidically separated from the inner circuit (2), through which ambient air (104) is directed by a second fan (5), wherein the inner circuit (2) and the outer circuit (3) are fluidically separated one from the other by means of a separating element (6), and wherein an inverter (7), via which a compressor (19) of the cooling device (1) is driven, comprises a heat exchanger (10) at a first side (8) of two opposing sides (8,9) for the exchange of waste heat to the air surrounding the heat exchanger (10) and, at a second of the two opposing sides (8,9), an electronics part (11) with multiple electronic components (12), **characterized in that** at least the heat exchanger (10) of the first side (8) of the inverter (7) is arranged in the outer circuit (3) and at least the electronics part (11) of the second side (9) of the inverter (7) is arranged in the inner circuit (2).

2. The cooling device (1) according to claim 1, in which the opposing sides of the inverter (7) are formed by an electric circuit board (13) of the inverter (7).

3. The cooling device (1) according to claim 1 or 2, in which the inverter (7) is inserted in an opening (14) of the separating element (6) between the inner circuit (2) and the outer circuit (3), so that the first side (8) of the inverter (7) is arranged in the outer circuit and the second side (9) of the inverter (7) is arranged in the inner circuit (2).

4. The cooling device (1) according to claim 3, in which the inverter (7) has a circumferential flange (15) between the opposing sides (8, 9), by means of which the inverter (7) is fluidically tightly connected to the separating element (6), so that the opening (14) is closed by the inverter (7).

5. The cooling device (1) according to any of the preceding claims, in which the heat exchanger (10) has a metallic cooling element (16) on a face side with which the heat exchanger (10) protrudes into the outer circuit (3), preferably a finned cooling element.

6. The cooling device (1) according to any of the preceding claims, in which a first air-coolant heat exchanger (17) is arranged in the outer circuit (3), wherein the first side (8) of the inverter (7) in the outer circuit (3) in the direction of the flow of the fluid through the outer circuit (3) is arranged between the first air-coolant heat exchanger (17) and the second fan (5).

7. The cooling device (1) according to any of the preceding claims, comprising a cooling unit with a compressor (19) in the outer circuit (3), a first air-coolant heat exchanger (17) in the outer circuit (3) and a second air-coolant heat exchanger (18) in the inner circuit (2), wherein the inverter (7) is arranged with its electronics part (11) in the air flow through the inner circuit (2) and with its heat exchanger (10) in the air flow through the outer circuit (3).

8. The cooling device (1) according to any of the preceding claims, comprising an air guide (19), by means of which the air flowing through the outer circuit (3) is directed to the heat exchanger (10).

9. The cooling device (1) according to claim 8, in which the air guide (19) is a component of the separating element (6) and/or is formed onto the same.

10. The cooling device (1) according to any of the preceding claims, in which the separating element (6) is a molded plastic part, in particular an injection-molded part, or a deep-drawn plastic or metal component.

## Revendications

1. Appareil de refroidissement (1) pour la climatisation d'armoires de commande, qui comprend un circuit interne (2) à travers lequel l'air à refroidir (103) est guidé hors d'un espace interne d'armoire de commande (101) au moyen d'un premier ventilateur (4), et un circuit externe (3), séparé fluidiquement du circuit interne (2), à travers lequel l'air ambiant (104) est guidé au moyen d'un deuxième ventilateur (5), le circuit interne (2) et le circuit externe (3) étant séparés fluidiquement entre eux par un élément de séparation (6) et un inverseur (7), par l'intermédiaire duquel un compresseur de l'appareil de refroidissement (1) est contrôlé, comprend, au niveau d'un premier (8) de deux côtés opposés (8, 9), un échangeur thermique (10) pour l'échange de la chaleur dégagée avec l'air entourant l'échangeur thermique (10) et, au niveau d'un deuxième des deux côtés opposés (8, 9), une partie électronique (11) avec une pluralité de composants électroniques (12), **caractérisé en ce qu'**au moins l'échangeur thermique (10) du premier côté (8) de l'inverseur (7) est disposé dans le circuit externe (3) et au moins la partie électronique (11) du deuxième côté (9) de l'inverseur (7) est disposée dans le circuit interne (2).

2. Appareil de refroidissement (1) selon la revendication 1, dans lequel les côtés opposés de l'inverseur (7) sont constitués par une carte de circuit électrique (13) de l'inverseur (7).

3. Appareil de refroidissement (1) selon la revendication 1 ou 2, dans lequel l'inverseur (7) est inséré dans un passage (14) de l'élément de séparation (6) entre le circuit interne (2) et le circuit externe (3), de façon à ce que le premier côté (8) de l'inverseur (7) soit disposé dans le circuit externe et le deuxième côté (9) de l'inverseur (7) soit disposé dans le circuit interne (2).

4. Appareil de refroidissement (1) selon la revendication 3, dans lequel l'inverseur (7) comprend, entre les côtés opposés (8, 9), une bride circulaire (15) par l'intermédiaire de laquelle l'inverseur (7) est relié de manière étanche fluidiquement avec l'élément de séparation (6), de façon à ce que le passage (14) soit obturé par l'intermédiaire de l'inverseur (7).

5. Appareil de refroidissement (1) selon l'une des revendications précédentes, dans lequel l'échangeur thermique (10) comprend, au niveau d'une face frontale, avec laquelle l'échangeur thermique (10) dépasse dans le circuit externe (3), un radiateur métallique (16), de préférence un radiateur nervuré.

6. Appareil de refroidissement (1) selon l'une des revendications précédentes, dans lequel, dans le circuit externe (3), est disposé un premier échangeur thermique air-produit de refroidissement (17), le premier côté (8) de l'inverseur (7) étant disposé dans le circuit externe (3), dans la direction d'écoulement du fluide à travers le circuit externe (3), entre le premier échangeur thermique air-produit de refroidissement (17) et le deuxième ventilateur (5).

7. Appareil de refroidissement (1) selon l'une des revendications précédentes, qui comprend un réfrigérateur avec un compresseur dans le circuit externe (3), un premier échangeur thermique air-produit de refroidissement (17) dans le circuit externe (3) et un deuxième échangeur thermique air-produit de refroidissement (18) dans le circuit interne (2), l'inverseur (7) étant disposé, avec sa partie électronique (11), dans le flux d'air à travers le circuit interne (2) et, avec son échangeur thermique (10) dans le flux d'air à travers le circuit externe (3).

8. Appareil de refroidissement (1) selon l'une des revendications précédentes, qui comprend un élément de guidage d'air (19) par l'intermédiaire duquel l'air traversant le circuit externe (3) est dévié vers l'échangeur thermique (10).

9. Appareil de refroidissement (1) selon la revendication 8, dans lequel l'élément de guidage d'air (19) fait partie de l'élément de séparation (6) et/ou est moulé sur celui-ci.

10. Appareil de refroidissement (1) selon l'une des revendications précédentes, dans lequel l'élément de séparation (6) est une pièce moulée en matière plastique, plus particulièrement une pièce moulée par injection ou un composant en matière plastique ou métallique emboutie.
